# EUROPÄISCHE PATENTANMELDUNG

(11) **EP 1 137 009 A2**
(43) Veröffentlichungstag der Anmeldung: **26.09.2001**
(21) Anmeldenummer: 01106086.0
(22) Anmeldetag: 13.03.2001
(51) Int. Cl.: G11C 11/22

(54) **Intergrierter Speicher mit Bitleitungsreferenzspannung und Verfahren zum Erzeugen der Bitleitungsreferenzspannung**

(30) Priorität: 23.03.2000 DE 10014387
(71) Anmelder: Infineon Technologies AG, 81669 München (DE)
(72) Erfinder: Böhm, Thomas, 85604 Zorneding (DE); Manyoki, Zoltan, CDN-Kanata, ON K2L 3W9 (CA); Esterl, Robert, 81827 München (DE); Röhr, Thomas, 85609 Aschheim (DE)
(74) Vertreter: Patentanwaltskanzlei WILHELM & BECK

(57) **Zusammenfassung**

Bei einem insbesondere ferroelektrischen Halbleiter-Speicher mit einem differentiellen Schreib-/Leseverstärker (SA), der über Transfertransistoren (T) mit einem aus einer Bitleitung (BLi) und einer entsprechenden Referenzbitleitung (/BLi) bestehenden Bitleitungspaar verbunden ist zum Lesen und Schreiben von Daten aus und in den Speicherkondensator (MC), ist zur Steigerung der Genauigkeit der Bitleitungsreferenzspannung vorgesehen, dass eine Hauptreferenzbitleitung (/BL0) über ein Ladungs-Schaltelement (TL) mit einer Referenzspannung (VREF) verbunden ist, und dass zumindest eine weitere Referenzbitleitung (/BLi) über ein Ausgleichs-Schaltelement (TA) zum Ladungsausgleich zwischen den Referenzbitleitungen mit der Hauptreferenzbitleitung verbunden ist.

## Beschreibung

Integrierter Speicher mit Bitleitungsreferenzspannung und Verfahren zum Erzeugen der Bitleitungsreferenzspannung

Die vorliegende Erfindung betrifft einen integrierten Speicher, insbesondere einen ferroelektrischen Speicher, mit Speicherkondensatoren, die in Kreuzungspunkten von Wortleitungen und Bitleitungspaaren bestehend aus einer Bitleitung und einer entsprechenden Referenzbitleitung mit einer Bitleitungsreferenzspannung angeordnet sind, mit einem Auswahltransistor, über den der Speicherkondensator mit der Bitleitung verbunden ist und dessen Steuerelektrode mit der Wortleitung verbunden ist, und mit einem differentiellen Schreib-/Leseverstärker der über Transfertransistoren mit dem Bitleitungspaar verbunden ist zum Lesen und Schreiben von Daten aus und in den Speicherkondensator, sowie ein entsprechendes Verfahren zum Erzeugen der Bitleitungsreferenzspannung integrierte Speicher.

Ein derartiger integrierter Speicher ist als DRAM oder FeRAM bekannt aus der Druckschrift DE 199 03 199 A1, wobei beispielsweise zum Auslesen von Daten aus einem ferroelektrischen Speicherkondensator einer Speicherzelle des 1-Transistor-1-Kondensator-Typs eine definierte Referenzspannung auf der Referenzbitleitung erforderlich ist. Die Information ist bei einem ferroelektrischen Speicherkondensator durch den Polarisationszustand des Dielektrikums gespeichert. Beim Auslesen der gespeicherten Information durch den differentiellen Leseverstärker kann auf der mit dem Speicherkondensator verbundenen Bitleitung für eine logische 1 aufgrund des entsprechenden Polarisationszustandes beispielsweise eine Spannung von 1,2 V und für eine logische 0 aufgrund des entgegengesetzten Polarisationszustandes ein Spannungswert von 0,5 V auftreten bzw. gemessen werden. Dieser Spannungswert wird über den differentiellen Verstärker mit der Referenzspannung der Referenzbitleitung verglichen. Der exakte Wert dieser Bitleitungsreferenzspannung wird dabei in einer Test-phase vorab ermittelt und die Referenzspannung entsprechend eingestellt. Dazu werden beispielsweise alle Speicherzellen des ferroelektrischen Speichers mit einer Spannung entsprechend einer logischen 0 beschrieben bzw. geeignet polarisiert. Dann wird eine bestimmte Bitleitungsreferenzspannung angelegt. Mittels des differentiellen Verstärkers werden alle Speicherzellen ausgelesen. Falls der Wert der Bitleitungsreferenzspannung zu niedrig gewählt war, werden fälschlicher Weise auch logische 1 ausgelesen. In einem nachfolgenden Schritt wird deshalb der Wert der Bitleitungsreferenzspannung erhöht und der Lesevorgang wiederholt. Dies wird so lange durchgeführt, bis alle gespeicherten logischen 0 richtig aus den ferroelektrischen Zellen ausgelesen werden. Im Anschluss daran werden alle Speicherzellen mit einer logischen 1 beschrieben und ausgehend von einer höheren Bitleitungsreferenzspannung die Speicherinhalte ausgelesen. Die Referenzspannung auf den Bitleitungen wird dabei so lange verringert, bis alle gespeicherten logischen 1 fehlerfrei ausgelesen werden können. Dabei ergibt sich für den getesteten Speicherchip ein Spannungsfenster, in dem die geeignete Referenzspannung gewählt werden muss. Nachteilig beim bekannten Stand der Technik ist dessen begrenzte Genauigkeit der Bitleitungsreferenzspannung. Denn übliche Referenzspannungsgeneratoren oder eine Referenzzelle erzeugen beispielsweise im Bereich von 0,3 bis 0,7 V eine Ausgangsspannung mit einer Spannungsgenauigkeit von absolut 30 mV auf den Bitleitungen. Der Wert des relativen Fehlers der Bitleitungsreferenzspannung ist demnach im Bereich von 10% bis 4,2%.

Aus der US 4,937,476 ist es bekannt bei einem integrierten Speicher die Referenzspannung für einen differenziellen Verstärker mittels eines Ladungs-Schaltelements, Ausgleichs-Schaltelementen und Kapazitäten zu erzeugen, wobei die Referenzspannung durch Ladungsausgleich zwischen den Kapazitäten zustande kommt.

Aufgabe der vorliegenden Erfindung ist es, bei einem Speicher nach dem Oberbegriff des Patentanspruches 1 die Genauigkeit der Bitleitungsreferenzspannung mit einfachen Mitteln zu erhöhen, und ein entsprechendes Betriebsverfahren zur Erzeugung der Bitleitungsreferenzspannung für den integrierten Speicher anzugeben.

Erfindungsgemäß ist dies bei einem Speicher nach dem Oberbegriff des Patentanspruches 1 dadurch erreicht, dass eine Hauptreferenzbitleitung über ein Ladungs-Schaltelement mit einer Referenzspannung verbunden ist, und dass zumindest eine weitere Referenzbitleitung über ein Ausgleichs-Schaltelement zum Ladungsausgleich zwischen den Referenzbitleitungen mit der Hauptreferenzbitleitung verbunden ist. Das erfindungsgemäße Verfahren zeichnet sich durch folgende Verfahrensschritte aus: Schalten einer Referenzspannung auf eine Hauptreferenzbitleitung, Trennen der Referenzspannung von der Hauptreferenzbitleitung, Parallelschalten zumindest einer weiteren Referenzbitleitung zur Hauptreferenzbitleitung, wodurch ein Ausgleich der in den parallel geschalteten parasitären Kapazitäten der Referenzbitleitungen gespeicherten Ladung erfolgt und die Referenzspannung in mehrere gleich große Bitleitungsreferenzspannungen aufgeteilt wird. Dabei ist es problemlos möglich, die Referenzspannung mit einem Spannungsgenerator zu erzeugen, dessen Ausgangsspannung im Vergleich zum Stand der Technik bei unveränderter absoluter Spannungsgenauigkeit von beispielsweise 30 mV deutlich größer ist, z.B. anstelle von 0,7 V beispielsweise 2,8 V. Der relative Fehler der Referenzspannungen auf den einzelnen Referenzbitleitungen ist dadurch offensichtlich entsprechend verringert. Wird diese vergrößerte Referenzspannung auf die parasitäre Kapazität einer ausgewählten Referenzbitleitung geladen und anschließend die dabei gespeicherte Ladung auf die parasitären Kapazitäten weiterer Referenzbitleitungen verteilt, weisen alle Bitleitungsreferenzspannungen einen entsprechend verringerten Fehler auf. Erzeugt man beispielsweise die Bitleitungsreferenzspannung mit einem Spannungsgenerator, der im Bereich von 1,2 V bis 2,8 V eine Ausgangsspannung mit einer Spannungsgenauigkeit von 30 mV aufweist, beträgt der Fehler auf den Referenzbitleitungen nach einem erfindungsgemäßen Ladungsausgleich bei vier miteinander verschalteten Referenzbitleitungen nur mehr 2,5% bis 1,0%. Dabei sind die vier Bitleitungsreferenzspannungen gleich groß, weil auch die vier parasitären Kapazitäten der Bitleitungen gleich groß sind.

Gemäß einer bevorzugten Ausführungsform ist die Referenzspannung durch eine Konstantspannungsquelle bereitgestellt. Dies ist schaltungstechnisch sehr einfach mit ausreichender Genauigkeit auch für größere Spannungswerte realisierbar. Alternativ könnte auch eine Referenzzelle verwendet werden, was aufgrund deren Alterung mit zunehmender Betriebsdauer zu einer reduzierten Genauigkeit der Referenzspannung führen kann. Außerdem wäre das Timing zum Erzeugen der Referenzspannung komplizierter.

Vorteilhafter Weise ist vorgesehen, dass vier Referenzbitleitungen mittels dreier Ausgleichs-Schaltelemente zum Ladungsausgleich miteinander verbunden sind. Dadurch ist zum einen eine Vervierfachung der Genauigkeit der Referenzspannungen auf den Referenzbitleitungen möglich. Zum anderen kann der Wert der auf die Hauptreferenzbitleitung geschalteten Spannung noch ausreichend gering gehalten werden. Dieser kann beispielsweise bei vier miteinander verschalteten Referenzbitleitungen bei 2,8 V liegen, wodurch sich nach dem Ladungsausgleich eine einheitliche Bitleitungsreferenzspannung von exakt 0,7 V ergeben kann.

Um ein einfaches Schaltungslayout zu erhalten, können die Ausgleichs-Schaltelemente in Form von Ausgleichstransistoren in Reihe geschaltet sein.

Gemäß einer bevorzugten Ausführungsform ist das Ladungs-Schaltelement als p-Kanal-Transistor realisiert, um die Steuerspannung an dessen Gate angesichts der vergleichsweise hohen zu übertragenden Referenzspannung von beispielsweise 2,8 V ausreichend gering halten zu können.

Nachfolgend sind anhand schematischer Darstellungen ein Ausführungsbeispiel der erfindungsgemäßen integrierten Speicheranordnung sowie ein Verfahren zur Erzeugung der Bitleitungsreferenzspannung beschrieben. Es zeigen
Fig. 1 abschnittsweise ein Schaltbild einer erfindungsgemäßen ferroelektrischen Speicheranordnung,
Fig. 2 in Ergänzung zu Figur 1 ein Schaltbild mit Schaltelementen zur Erzeugung der Bitleitungsreferenzspannungen, und
Fig. 3 ein Spannungs-Zeit-Diagramm der Bitleitungsreferenzspannungen bei der Schaltungsanordnung gemäß Figuren 1 und 2 beim erfindungsgemäßen Verfahren.

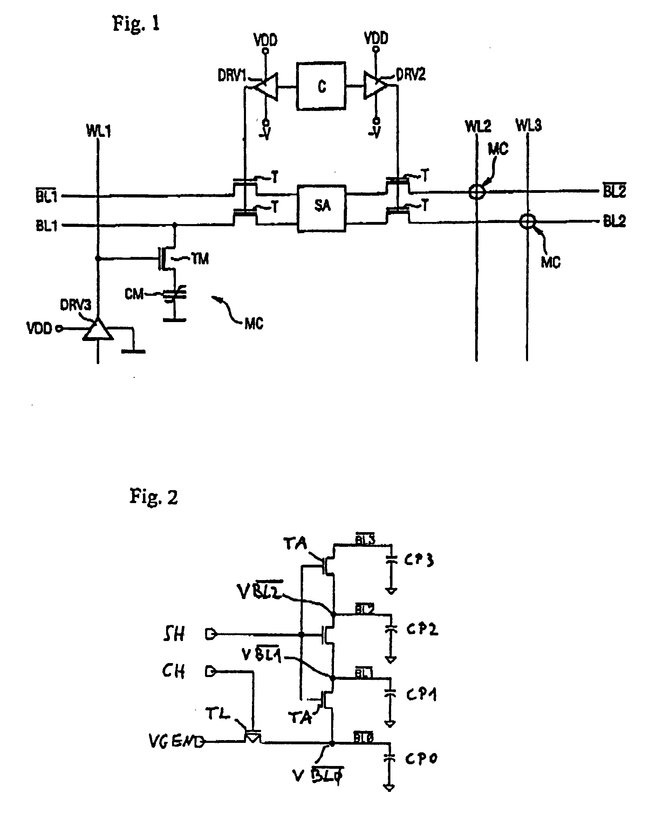

Ein ferroelektrischer Speicher (FeRAM) weist gemäß Figur 1 in bekannter Weise in Kreuzungspunkten von Wortleitungen WLi und Bitleitungspaaren, die jeweils aus Bitleitungen BLi und Referenzbitleitungen /BLi bestehen, Speicherzellen MC vom 1-Transistor-1-Kondensator-Typ auf. Ein Auswahltransistor TM jeder Speicherzelle MC verbindet einen ferroelektrischen Speicherkondensator CM der Speicherzelle MC mit der jeweils zugehörigen Bitleitung. Das Gate des Auswahltransistors TM ist mit der zugehörigen Wortleitung WLi verbunden. In Figur 1 sind aus Vereinfachungsgründen lediglich zwei Bitleitungspaare BL1,/BL1, BL2,/BL2 sowie drei Wortleitungen WL1, WL2, WL3 dargestellt. Offensichtlich besitzt ein FeRAM in der Praxis eine viel größere Anzahl von Bitleitungen und Wortleitungen. Die gezeigte Speicheranordnung weist weiterhin einen Leseverstärker SA auf, der mit einzelnen Bitleitungen eines Bitleitungspaares jeweils über einen Transfertransistor T verbunden ist. Bei dem Leseverstärker SA handelt sich um einen bekannten differentiellen Verstärker, der bei einem Lesezugriff auf den Speicherkondensator CM eine Spannungsdifferenz auf dem dazugehörigen Bitleitungspaar (BLi,/BLi) verstärkt und auf nicht weiter dargestellte Datenleitungen weitergibt. Diese Potenzialdifferenz resultiert bei einem Lesezugriff daher, dass eine der Bitleitungen (/BLi) des jeweiligen Bitleitungspaares als die eine definierte Referenzspannung aufweisende Referenzbitleitung dient, während der Inhalt des Speicherkondensators CM auf die zugehörige andere Bitleitung (BLi) des Bitleitungspaares ausgelesen wird. Der Leseverstärker SA dient jedoch auch bei Schreibzugriffen einer Übertragung von ihm zugeführten Daten über eines der Bitleitungspaare zu den ferroelektrischen Speicherzellen MC. Der Leseverstärker SA kann beispielsweise durch eine bei DRAMs übliche Flip-Flop-Schaltung realisiert sein. Die Transfertransistoren T können so angesteuert werden, dass sie zu einem Zeitpunkt nur eines der Bitleitungspaare BLi,/BLi mit dem Leseverstärker SA verbinden. Somit kann der Leseverstärker entweder auf das linke Bitleitungspaar BL1,/BL1 oder auf das rechte Bitleitungspaar BL2,/BL2 zugreifen. Der in Figur 1 dargestellte Speicher weist weiterhin eine Steuereinheit C auf, die zur Ansteuerung der Transfertransistoren T dient. Ausgänge der Steuereinheit C sind über je einen Treiber DRVi mit den Transfertransistoren T je eines der Bitleitungspaare BLi,/BLi verbunden. Die Treiber DRVi werden durch ein positives Versorgungspotenzial VDD und ein negatives Potenzial -V versorgt und liefern Ausgangssignale, die ebenfalls diese Pegel aufweisen. Die Wortleitungen WLi werden über einen nicht dargestellten Wortleitungsdecoder und weitere Treiber DRV3, von denen in der Figur 1 nur einer dargestellt wurde, angesteuert. Die weiteren Treiber DRV3 werden durch das positive Versorgungspotenzial VDD und Masse versorgt. Daher sind die Wortleitungen WLi entweder auf dem positiven Versorgungspotenzial VDD oder auf Massepotenzial. An den Gates der Transfertransistoren T liegt dagegen im gesperrten Zustand das negative Potenzial -V an, das unterhalb der Einsatzspannung dieser Transistoren liegt. Da es sich bei den Transfertransistoren T um selbstleitende Transistoren handelt, ist ihre Einsatzspannung negativ. Das negative Potenzial -V ist so gewählt, dass die Transfertransistoren T bei Anliegen dieses Potenzials an Ihrem Gate sicher sperren.

Um die Bitleitungsreferenzspannung V/BLi beispielsweise für einen Lesevorgang aus dem ferroelektrischen Speicherkondensator CM der Schaltungsanordnung gemäß Fig. 1 erzeugen zu können, ist diese um die Schaltungsanordnung gemäß Figur 2 ergänzt. Dabei sind beispielhaft jeweils vier Speicherzellen MC und deren Referenzbitleitungen /BLi zu einer Schaltungseinheit mit einer gemeinsamen Erzeugung der Bitleitungsreferenzspannung zusammengefasst. Aus Vereinfachungsgründen sind in Figur 2 lediglich die Referenzbitleitungen /Bli und die zur Erzeugung der Bitleitungsreferenzspannung V/BLi erforderlichen Schaltungselemente ohne die Speicherkondensatoren dargestellt. Dabei ist Figur 2 jedoch um zwei weitere Referenzbitleitungen /BL0 und /BL3 ergänzt. Die Referenzbitleitung /BLO dient gemäß Figur 2 als Hauptreferenzbitleitung. Diese weist wie alle anderen Referenzbitleitungen eine parasitäre Bitleitungskapazität CPi auf. Der Wert der parasitären Bitleitungskapazitäten kann dabei beispielsweise bei typisch 150 fF liegen und ist damit deutlich größer als der Wert der Kapazität des ferroelektrischen Speicherkondensators CM. Die Hauptreferenzbitleitung /BL0 ist über einen Ladungstransistor TL, der vom p-Kanal-Typ ist, mit einem Referenzpotenzial VGEN verbunden. Dieses wird von einem an sich bekannten Spannungsgenerator bereitgestellt und liegt beispielsweise in einem Bereich von 1,2 V bis 2,8 V mit einer Spannungsgenauigkeit von 30 mV. Der relative Fehler der Spannung beträgt demnach 2,5% bis 1%. Das Gate des Ladungstransistors TL ist mit einem Charge-Signalanschluss der Steuereinheit CH (Figur 2) verbunden. Weiterhin ist die Hauptreferenzbitleitung /BLO über drei in Reihe geschaltete Ausgleichstransistoren TAi mit den drei weiteren Referenzbitleitungen /BL1, /BL2, /BL3 verbunden. Die Gates der Ausgleichstransistoren TA sind wiederum gemeinsam mit einem Share-Signalanschluss der Steuereinheit CH (Figur 2) verbunden. Alle weiteren als Referenzbitleitungen dienenden Bitleitungen des ferroelektrischen Speichers sind zur genauen Erzeugung der Bitleitungsreferenzspannung ebenfalls entsprechend Figur 2 in Vierergruppen miteinander verschaltet. Dabei könnten alternativ beispielsweise auch BL1, /BL1, BL2, /BL2 als entsprechende Referenzbitleitungs-Vierergruppe miteinander verschaltet sein.

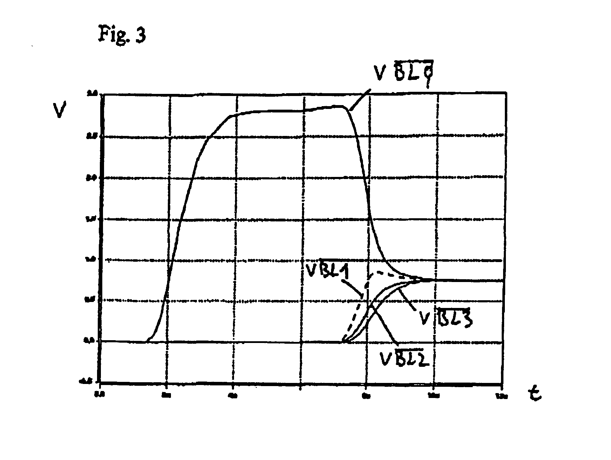

Die Funktion bzw. das Betriebsverfahren der in den Figuren 1 und 2 gezeigten Schaltungsanordnung wird nachfolgend mit Hilfe des in Figur 3 gezeigten Spannungs-Zeit-Diagrammes für die Bitleitungsreferenzspannungen V/BLi erläutert. Dabei wird davon ausgegangen, dass gilt: VGEN = 2,8 V. Zum Zeitpunkt t = 0 beträgt der Wert der Spannung V auf allen Referenzbitleitungen beispielsweise 0 V. Der Ladungstransistor TL und die Ausgleichstransistoren TA bzw. die dadurch realisierten Schalter sind geöffnet (CH = 1, SH = 0). Etwa zum Zeitpunkt t = 1,5 ns wird zur Vorbereitung eines Lesevorganges aus dem Speicherkondensator CM über das Bitleitungspaar BL1, /BL1 (Figur 1) das Ladungssignal CH auf 1 gesetzt. Der durch den Ladungstransistor TL realisierte Schalter wird also geschlossen. Die mit der Referenzspannungsquelle dadurch verbundene parasitäre Kapazität CP0 der Hauptreferenzbitleitung /BL0 wird auf den Wert des Referenzpotenzials VREF = 2,8 V geladen. Dieser Wert wird etwa zum Zeitpunkt t = 6 ns erreicht, wobei der Zeitverlauf gemäß Figur 3 durch den Wert der parasitären Kapazität, dem On-Widerstand des Ladungstransistors TL sowie dem Widerstand der Referenzbitleitung /BL0 bestimmt ist. Um den Ladevorgang möglichst schnell durchführen zu können, kann der On-Widerstand des Ladungstransistors TL möglichst gering gewählt werden bzw. der Transistor TL mit einer kleineren Gatespannung angesteuert werden. Etwa zum Zeitpunkt t = 7,5 ns wird der durch den Ladungstransistor TL realisierte Schalter geöffnet (CH = 1). Dadurch wird die parasitäre Kapazität der Hauptreferenzbitleitung /BL0 von der Referenzspannungsquelle getrennt. Weiterhin werden die durch die drei Ausgleichstransistoren TA realisierten Schalter geschlossen; d.h. es wird gesetzt CH = 1 und SH = 1. Die auf der parasitären Kapazität CP0 der Hauptreferenzbitleitung /BL0 gespeicherte Ladung verteilt sich nun auch auf die mit ihr verbundenen drei parasitären Kapazitäten CP1, CP2, CP3 der weiteren Referenzbitleitungen /BL1, /BL2 /BL3. Aufgrund der unterschiedlichen Leitungswiderstände fließt die auf der parasitären Kapazität CP0 der Hauptreferenzbitleitung gespeicherte Ladung unterschiedlich schnell auf die anderen drei parasitären Bitleitungskapazitäten CP1, CP2, CP3. Alternativ könnte auch vorgesehen sein, dass die einzelnen Ausgleichstransistoren TA zeitlich versetzt nacheinander eingeschaltet werden. Dies würde jedoch zu einer Verlangsamung des Ladungsausgleichs führen. Gemäß Figur 3 haben die Bitleitungspotenziale VBLi zum Zeitpunkt t = 10 ns aufgrund des erfolgten Ladungsausgleichs alle den gleichen Wert von exakt 2,8 V / 4 = 0,7 V erreicht. Die relative Genauigkeit der vier Potenzialwerte beträgt dabei bei einer relativen Genauigkeit der Referenzspannungsquelle von beispielsweise 2% ebenfalls exakt 2%. Die exakte Übereinstimmung der vier Potenzialwerte ergibt sich dabei aus der exakten Übereinstimmung der Werte der vier parasitären Bitleitungskapazitäten CPi. Zum Zeitpunkt t = 12 ns werden dann die drei Ausgleichstransistoren TA wieder abgeschaltet bzw. SH = 0 gesetzt. Die Referenzbitleitungen BLi sind also wieder voneinander getrennt, um eine nachteilige gegenseitige Beeinflussung beim nachfolgenden Auslesevorgang sicher ausschließen zu können. Dann werden durch die Steuereinheit C gesteuert die durch die Transfertransistoren T realisierten Schalter geschlossen und der differentielle Leseverstärker SA liest den Inhalt des Speicherkondensators CM aus bzw. schreibt die logische Information anschließend wieder in die Speicherzelle zurück. Dazu wird, wie oben beschrieben ist, die Differenz der Potenziale der Bitleitung BL1 und der Referenzbitleitung /BL1 gemessen.

## Patentansprüche

1. Integrierter Speicher, insbesondere ferroelektrischer Speicher, mit Speicherkondensatoren (MC), die in Kreuzungspunkten von Wortleitungen (WLi) und Bitleitungspaaren (BLi,/BLi) bestehend aus einer Bitleitung (BLi) und einer Referenzbitleitung (/BLi) mit einer Bitleitungsreferenzspannung (V/Bli) angeordnet sind, mit einem Auswahltransistor (TM), über den der Speicherkondensator mit der Bitleitung verbunden ist und dessen Steuerelektrode mit der Wortleitung verbunden ist, und mit einem differentiellen Schreib-/Leseverstärker (SA), der über Transfertransistoren (T) mit dem Bitleitungspaar verbunden ist zum Lesen und Schreiben von Daten aus und in den Speicherkondensator (MC),
**dadurch gekennzeichnet, dass**
eine Hauptreferenzbitleitung (/BL0) über ein Ladungs-Schaltelement (TL) mit einer Referenzspannung (VREF) verbunden ist, und dass zumindest eine weitere Referenzbitleitung (/BLi) über ein Ausgleichs-Schaltelement (TA) zum Ladungsausgleich zwischen den parasitären Kapazitäten der Referenzbitleitungen mit der Hauptreferenzbitleitung verbunden ist.

2. Speicher nach Anspruch 1, **dadurch gekennzeichnet, dass** die Referenzspannung (VREF) durch eine Referenzspannungsquelle bereitgestellt ist.

3. Speicher nach Anspruch 1 oder 2, **dadurch gekennzeichnet, dass** die Hauptreferenzbitleitung (/BL0) mit drei weiteren Referenzbitleitungen (/BLi) mittels dreier Ausgleichs-Schaltelemente (TA) zum Ladungsausgleich verbunden ist.

4. Speicher nach einem der vorhergehenden Ansprüche,
**dadurch gekennzeichnet, dass** die Ausgleichs-Schaltelemente (TA) in Reihe geschaltet sind.

5. Speicher nach einem der vorhergehenden Ansprüche,
**dadurch gekennzeichnet, dass** als das Ladungs-Schaltelement (TL) ein p-Kanal-Transistor dient.

6. Verfahren zum Erzeugen einer Referenzspannung (V/BLi) auf Referenzbitleitungen (/BLi) eines integrierten Speichers, insbesondere eines ferroelektrischen Speichers, mit Speicherkondensatoren (CM), wobei mittels eines differentiellen Verstärkers (SA) Daten aus dem mit einem Bitleitungspaar (BLi, /BLi), das aus einer Bitleitung (BLi) und einer entsprechenden Referenzbitleitung (/BLi) mit einer Bitleitungsreferenzspannung (V/Bli) besteht, verbundenen Speicherkondensator (CM) ausgelesen werden, mit folgenden Verfahrensschritten: Schalten einer Referenzspannung (VGEN) auf eine Hauptreferenzbitleitung (/BL0), Trennen der Referenzspannung (VGEN) von der Hauptreferenzbitleitung (/BL0), Parallelschalten zumindest einer weiteren Referenzbitleitung (/BL1, /BL2, /BL3) zur Hauptreferenzbitleitung, wodurch ein Ausgleich der in den parallel geschalteten parasitären Kapazitäten (CPi) der Referenzbitleitungen gespeicherten Ladung erfolgt und die Referenzspannung (VREF) in mehrere gleich große Bitleitungsreferenzspannungen (V/BLi) aufgeteilt wird.

7. Verfahren nach Anspruch 6, **dadurch gekennzeichnet, dass** nach dem Ladungsausgleich auf den Referenzbitleitungen (/BLi) diese durch Ausgleichs-Schaltelemente (TA) wieder voneinander getrennt werden.
